# EUROPEAN PATENT APPLICATION

(11) **EP 3 021 369 A1**
(43) Date of publication of application: **18.05.2016**
(21) Application number: 14193240.0
(22) Date of filing: 14.11.2014
(51) Int. Cl.: H01L 35/32

(54) **Thermoelectric power generator**

(71) Applicant: J Touch Corporation, Taoyuan Hsien 320 (TW)
(72) Inventor: Yeh, Yu-Chou, 320 Taoyuan County (TW); Wang, Yu Hsin, 320 Taoyuan County (TW); Wu, Chen-Chi, 320 Taoyuan County (TW); Yeh, Tsung-Her, 242 New Taipei City (TW); Hu, Chih-Ming, 320 Taoyuan Hsien (TW); Lin, Ting-Ching, 320 Taoyuan County (TW); Tsui, Chiu Cheng, 320 Taoyuan County (TW); Cheng, Bo Ruei, 320 Taoyuan County (TW); Yeh, Chun Ting, 320 Taoyuan County (TW); Wang, Yu Ju, 320 Taoyuan County (TW)
(74) Representative: Viering, Jentschura & Partner mbB Patent- und Rechtsanwälte

(57) **Abstract**

Disclosure is related to a thermoelectric power generator. The generator essentially includes a thermoelectric thin-film element (201) which is such as a thin film used to generate voltages according to a temperature difference. The output electric signals are converted to energy stored in an energy storage element (203). An output circuit (205) is included to output power. In an exemplary embodiment, the thermoelectric power generator has a contact interface (30) for sensing external temperate. The thermoelectric thin-film element (201) is enabled to output voltages when temperature difference is induced. The generator further has a switch (503), which is used to control if the power is output. The output element is such as a light-emitting element.

## Description

### BACKGROUND

### 1. Technical Field

The present invention relates to a thermoelectric power generator; in particular to a power generator utilizing a thermoelectric thin film capable of generating electric power in response to a temperature difference.

### 2. Description of Related Art

The thermoelectric effect appears as an energy conversion effect for generating electric voltage based on a temperature difference. Specifically, a thermoelectric device employing the thermoelectric effect is able to generate voltage signals when there is a temperature difference between two sides of the device. Conversely, when a voltage is applied to the thermoelectric device, a temperature difference is also produced. Therefore, the thermoelectric effect may be used to control temperature gradient by controlling the voltages, generating electric power, or measuring the temperature.

According to general applications, the thermoelectric device includes an electric loop composed of two joined metals. Since the metals are with different densities of free electrons, the electrons over a joint surface spread for eliminating the difference of the electron densities when the two metals are joined. Also, because of the spreading rate of electrons is proportional to the temperature of the joint surface, a temperature difference occurs at the joint surface. The temperature difference then induces a thermal electromotive force. The electrons will continuously spread out and flow when the temperature difference between the metals maintains. Therefore, the voltages are also generated.

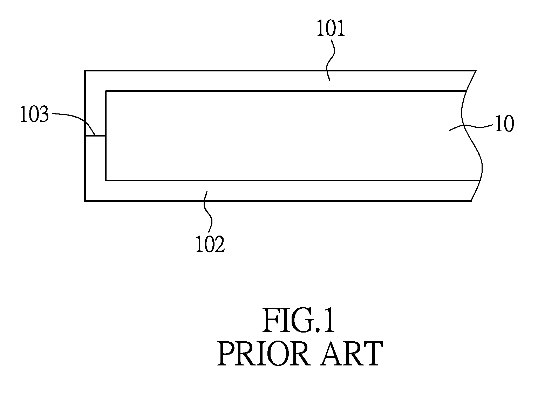

A kind of thermoelectric thin film utilizing the thermoelectric effect is provided. The thin-film device includes two different metals or different types of semiconductor materials. For example, the semiconductor materials are such as P-type semiconductor and N-type semiconductor. Reference is made to Fig. 1 schematically depicting a thermoelectric thin film device. In the diagram, the thermoelectric thin film device appears a combination of an insulating substrate 10, and a first conductor 101 and a second conductor 102 formed on two sides of the substrate 10. The first conductor 101 and the second conductor 102 are such as two kinds of metals, or two types of semiconductors such as P-type and N-type semiconductors. The first conductor 101 is joined with the second conductor 102 through a connecting member 103 as shown in the diagram.

More, the connecting member 103 may be placed at a region of high temperature, and the other sides, e.g. the two floating sides of the semiconductors 101, 102, may be placed at a region of lower temperature. Therefore, a temperature difference occurs. The conductor material at the high temperature has higher thermal activation, and higher density of electrons and electron holes. The electrons and the electron holes may spread to the lower temperature. An electric potential difference is generated inside the device and a voltage signal is also formed. The thermoelectric thin film accordingly converts the energy.

### SUMMARY

In the disclosure, a thermoelectric power generator is provided. The major elements of the thermoelectric power generator are such as a thermoelectric thin-film element, which is the thin-film element capable of generating a voltage in response to a temperature difference, disposed with an electric connection interface for outputting electric signals; an energy storage element connected with the thermoelectric thin-film element via the electric connection interface, and used to receive the electric signals and convert the electric signals into energy to be stored; and an output circuit used to output the stored energy.

According to one of the embodiments, the thermoelectric thin-film element of the thermoelectric power generator is disposed with a contact interface for sensing external temperature, and the thin-film element is able to generate voltage signals in response to the temperature difference. A switch may be disposed with the thermoelectric power generator. The switch is used to control if the electric power is outputted. An output end has a driving circuit. The driving circuit drives a load element by the output electric power. The load element is exemplified to be a light-emitting element.

In order to further understand the techniques, means and effects of the present disclosure, the following detailed descriptions and appended drawings are hereby referred to, such that, and through which, the purposes, features and aspects of the present disclosure can be thoroughly and concretely appreciated; however, the appended drawings are merely provided for reference and illustration, without any intention to be used for limiting the present disclosure.

### BRIEF DESCRIPTION OF THE DRAWINGS

Fig. 1 shows a schematic diagram depicting structure of a conventional thermoelectric thin film;
Fig. 2 shows a block diagram depicting a basic circuitry of a thermoelectric power generator in accordance with the present invention;
Fig. 3 shows a schematic diagram depicting circuitry of the thermoelectric power generator in one embodiment of the present invention;
Fig. 4 schematically shows a thermoelectric power generator in one embodiment according to the present invention;
Fig. 5 schematically shows a thermoelectric power generator in another one embodiment according to the present invention.

### DESCRIPTION OF THE EXEMPLARY EMBODIMENTS

Reference will now be made in detail to the exemplary embodiments of the present disclosure, examples of which are illustrated in the accompanying drawings. Wherever possible, the same reference numbers are used in the drawings and the description to refer to the same or like parts.

According to one of the embodiments of the present invention, this disclosure is related to a thermoelectric power generator. The thermoelectric power generator introduces a thermoelectric effect to conduct energy conversion between thermal energy and electrical energy. The thermoelectric effect is such as the Seebeck effect, Peltier effect, and Thomson effect. The terminals of the two different types of conductors or semiconductors are connected to form a closed circuit. Since the thermoelectric effect leads to energy conversion, a voltage can be induced if a temperature difference occurs between the two terminals. The mentioned different types of conductors are such as two kinds of metals, and the different semiconductors are such as a P-type semiconductor and an N-type semiconductor. It is noted that a thermoelectric coefficient, also known as Seebeck coefficient, is a measure of an induced thermoelectric voltage in response to per unit of temperature difference.

In general, some factors such as the magnitude of temperature difference, property of conductor, e.g. thermoelectric coefficient, any substance influencing the conductor, or/and design of circuit may impact the thermoelectric voltage and the thermoelectric coefficient due to the thermoelectric effect. Thus the larger temperature difference may make higher thermoelectric voltage or potential difference.

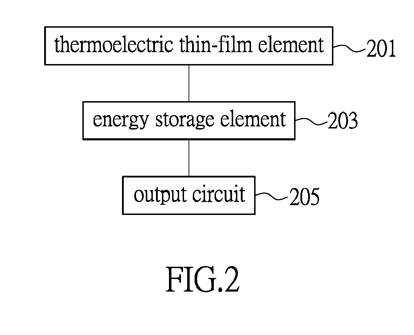

The design of apparatus based on the thermoelectric effect is such as a circuit diagram of thermoelectric power generator in one embodiment shown in Fig. 2.

The thermoelectric power generator is schematically shown in the diagram. One of the major elements thereof is such as a thermoelectric thin-film element 201. The thermoelectric thin-film element 201 is a thin-film element capable of generating voltage in response to a temperature difference. The related structure has substance which is capable of sensing a difference between an external temperature and an internal temperature. The temperature difference induces electric signals. The thermoelectric power generator includes an electric connection interface used to output electric signals. The electric connection interface is such as a circuit or line for outputting voltage signals. Via the electric connection interface, the thermoelectric thin-film element 201 is electrically connected with an energy storage element 203.

The energy storage element 203 is such as a chargeable battery. The energy storage element 203 is electrically connected with an electric connection interface, shown as a linking line, of the thermoelectric thin-film element 201. The energy storage element 203 is used to receive the electric signals, and convert the signals into energy to be stored.

While the energy storage element 203 is a chargeable battery, the element 203 is rechargeable when the electric power exhausts. The general chargeable battery is such as a super capacitor, a Nickel hydrogen battery, a Nickel-Cadmium battery, or a Lithium ion battery. However, the energy storage element 203 is not limited to any specific type of chargeable battery.

When the energy storage element 203 has stored energy, an output circuit 205 is provided to output the electric power. In one embodiment of the present invention, the electric power is provided to drive a light-emitting element or some other kinds of loads. For example, a light-emitting diode module is adopted to be an illuminator; and a laser module is driven to be a light beam pointer. Furthermore, the vehicle or house key, and a remote control for activating a specific device which requires small electric power may also be included.

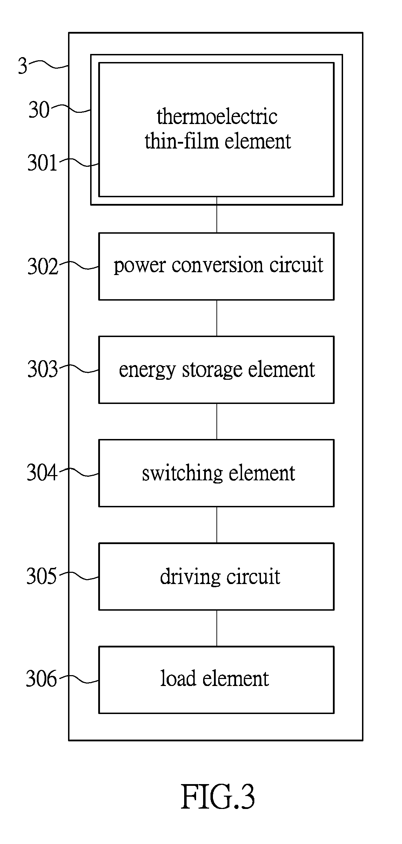

Reference is made to Fig. 3 showing the circuit of the thermoelectric power generator in one embodiment of the present invention.

In the diagram, the shown thermoelectric power generator includes a casing 3. A switch is disposed on the casing 3. The switch is electrically connected with an internal switching element 304. The switch is provided for a user to control the energy storage element if outputting electric power.

The thermoelectric power generator has a thermoelectric thin-film element 301. The thermoelectric thin-film element 301 is a thin-film element for generating electric signals in response to the temperature difference. The thermoelectric power generator has an outward contact interface 30. The contact interface 30 may be a window allowed to be touched. The contact interface 30 may be a portion of the casing 3 if the casing 3 is made of a heat conductive material. The thermoelectric power generator is able to sense external temperature through this contact interface 30. That means the thermoelectric thin-film element 301 senses the temperature through the contact interface 30. When a temperature difference is found over the contact interface 30, the thermoelectric thin-film element 301 can generate electric signals in response to the temperature difference.

Further, the thermoelectric power generator is exemplarily disposed with an energy storage element 303 for storing energy. In practice, the energy storage element 303 is such as a chargeable battery, super capacitor, or other kinds of charging circuits. The generator is disposed with a power conversion circuit 302. The power conversion circuit 302 is electrically connected with the thermoelectric thin-film element 301 and the energy storage element 303. The power conversion circuit 302 is used to convert the electric signals generated by the thermoelectric thin-film element 301 to energy which may be stored in the energy storage element 303.

One of the functions rendered in the power conversion circuit 302 is to convert the electric signals to energy to be stored in the energy storage element 303. A power conversion circuit 302 acts as a control circuit for the energy storage element 303. According to one specific embodiment, inside the power conversion circuit 302, a boost charging circuit, a protection circuit for protecting the energy storage element 303, voltage regulator circuit, or/and direct-current conversion circuit may be included. Further, the power conversion circuit 302 is able to convert electric signals to voltage or current supplied to the energy storage element 303 in compliance with a charging procedure. The charging current is adjustable with change of the battery voltage. For example, the charging current gradually decreases as the battery voltage gets high.

The thermoelectric power generator is disposed with a switching element 304 electrically connected with the energy storage element 303. The switching element 304 electrically connects to the switch on the casing 3. The switch is provided to control the energy storage element 303 outputting electric power. This switch may be implemented as, but not limited to, a DIP switch, a push-button switch, or a knob button disposed on the casing 3.

Still further, the thermoelectric power generator has a driving circuit 305 which is used to drive the circuit for a load element 306. The driving circuit 305 may conduct, boost or adjust voltage for driving a load element 306. The driving circuit 305 is electrically connected to the switching element 304. The switching element 304, electrically connected with the energy storage element 303 and the output circuit, is used to control outputting electric power or blocking outputting electric power. The driving circuit 305 drives the load element 306 with the electric power in the energy storage element 303.

In an exemplary example, the load element 306 is a circuit component driven by the electric power generated by this thermoelectric power generator. The load element 306 can be a light-emitting element. For example, the element may be a laser module which may act as a light beam pointer. Some further applications are such as an incandescent light bulb or light-emitting diode module which is to be an illuminator.

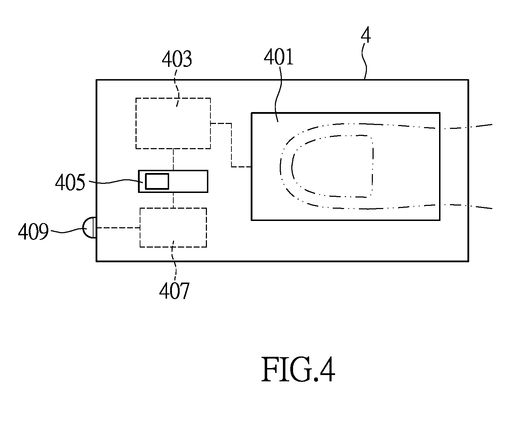

In Fig. 4, the diagram shows a circumstance with the thermoelectric power generator in one embodiment of the present invention. The thermoelectric power generator's casing 4 has a contact interface coupled with the inside of the thermoelectric thin-film element 401. The contact interface is such as a window of the thermoelectric thin-film element 401 that allows a user to use his finger to press on. A temperature different exists between the body temperature and an ambient temperature when the finger presses on the window. Therefore electric signals are induced due to the thermoelectric effect. The electric signals are essentially converted to the energy able to be stored in the energy storage element 403.

It is noted that the contact interface is such a heat transmission device provided to sense temperature when a user's finger is placed on the contact interface.

The internal switching element 405 is provided for the user to switch on or off the output of electric power. The switching element 405 also controls the driving circuit 407 if outputting electric power. The driving circuit 407 is such as a driving circuit to drive a light-emitting element 409.

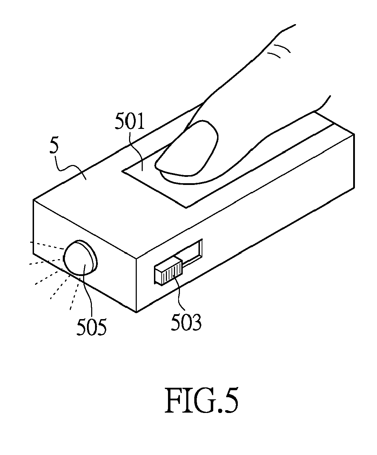

Reference is made to Fig. 5 depicting a schematic diagram of the thermoelectric power generator. The thermoelectric power generator 5 is disposed with a contact window 501. The contact window 501 is provided for the user to press his finger on. Therefore, the body temperature can be transmitted to the thermoelectric thin-film element. Through this thermoelectric power generator, the electric power may be firstly stored to the energy storage element of the thermoelectric power generator 5. A switch 503 is disposed in the thermoelectric power generator 5. The switch 503 allows controlling whether the electric power is to be outputted or not. The switch 503 is exemplarily used to switch on or off the operation of light-emitting element 505. The light-emitting element 505 is such as an incandescent light bulb, a light-emitting diode module or a laser module. Furthermore, the thermoelectric power generator 5 may also be introduced to other applications requiring power supply.

It is worth noting that, in accordance with the circuit of the thermoelectric power generator, the generator is able to convert the change of environmental temperature into the current signals made by the electric power. The generator is able to directly output the power, or store the electric power into an energy storage element. Alternatively, the energy storage element may be used to store the remaining power other than the supplied electric power. When the energy storage element does not supply enough electric power, the generator allows the user to press his finger or utilize the change of environmental temperature to generate more power for the specific use.

To sum up, the thermoelectric power generator in accordance with the present invention incorporates a thermoelectric thin-film element to generating electric signals in response to a temperature difference based on the effect of thermoelectricity. According to one of the embodiments, the apparatus allows the user to press his finger on a contact window to produce temperature difference for generating more energy. Therefore the apparatus is able to output electric power directly, or store the energy into an energy storage element such as a capacitor or a chargeable battery in advance. The apparatus also provides a switch to control the electric power output. The thermoelectric power generator may also be a standalone apparatus to supply electric power for some specific uses.

The above-mentioned descriptions represent merely the exemplary embodiment of the present disclosure, without any intention to limit the scope of the present disclosure thereto. Various equivalent changes, alterations or modifications based on the claims of the present disclosure are all consequently viewed as being embraced by the scope of the present disclosure.

## Claims

1. A thermoelectric power generator, comprising:
a thermoelectric thin-film element (201), being a thin-film element used to generate electric signals in response to a temperature difference, and with an electric connection interface used to output the electric signals;
an energy storage element (203), electrically connected with the electric connection interface of the thermoelectric thin-film element (201), receiving the electric signals and converting the electric signals to energy to be stored; and
an output circuit (205), electrically connected with the energy storage element (203), used to output electric power.

2. The thermoelectric power generator of claim 1, wherein the thermoelectric thin-film element (201) is disposed with a contact interface (30) which is used to sense external temperature.

3. The thermoelectric power generator of claim 2, wherein the contact interface (30) is a heat transmission device provided to sense temperature when a user's finger is placed on the contact interface (30).

4. The thermoelectric power generator of claim 1, further comprising a switching element (304), electrically connected with the energy storage element (203) and the output circuit (205), used to control outputting electric power or blocking outputting electric power.

5. A thermoelectric power generator, comprising:
a casing (4), on which a switch (503) is disposed, inside the casing (4)
having:
a thermoelectric thin-film element (201) with a contact interface (30) used to sense external temperature, wherein the thermoelectric thin-film element (201) is a thin-film element used to generate electric signals in response to a temperature difference as compared with the external temperature;
an energy storage element (203) used to store energy;
a power conversion circuit (302), electrically connected with the thermoelectric thin-film element (201) and the energy storage element (203), used to convert the electric signals generated by the thermoelectric thin-film element (201) to the energy charging the energy storage element (203);
a switching element (304), electrically connected with the energy storage element (203), connected with the switch (503) on the casing (4), used to control the energy storage element (203) if outputting electric power; and
a driving circuit (305), electrically connected with the switching element (304), used to drive a load element (306) which is powered by the electric power outputted from the energy storage element (203).

6. The thermoelectric power generator of claim 5, wherein the load element (306) is a light-emitting element (409).

7. The thermoelectric power generator of claim 6, wherein the light-emitting element (409) is a laser module to be a light beam pointer.

8. The thermoelectric power generator of claim 6, wherein the light-emitting element (409) is an incandescent light bulb to be an illuminator or a light-emitting diode module.

9. The thermoelectric power generator of claim 5, wherein the power conversion circuit (302) further comprises a charging circuit for electrically charging the energy storage element (203), and a protection circuit.

10. The thermoelectric power generator of claim 5, wherein the switch (503) is a DIP switch or a push-button switch disposed on the casing (4).
